# EUROPÄISCHE PATENTANMELDUNG

(11) **EP 0 734 200 A1**
(43) Veröffentlichungstag der Anmeldung: **25.09.1996**
(21) Anmeldenummer: 96200464.4
(22) Anmeldetag: 22.02.1996
(51) Int. Cl.: H05K 13/00, H05K 7/14

(54) **Montagehilfe für den Einbau einer Leiterplatte in ein Gehäuse**

(30) Priorität: 25.02.1995 DE 19506668
(71) Anmelder: Valeo Borg Instruments Verwaltung GmbH, 75196 Remchingen (DE)
(72) Erfinder: Behrends, Heinrich, D-76332 Bad Herrenalb (DE); Ziegler, Wolfgang, Dr., D-76307 Karlsbad-Ittersbach (DE)
(74) Vertreter: COHAUSZ HASE DAWIDOWICZ & PARTNER

(57) **Zusammenfassung**

Montagehilfe in Form axial verschieblicher Distanzstücke (13) für den Einbau von Leiterplatten (6,8) in ein aus mindestens zwei Teilen bestehendes Gehäuse, mit einem elektrische Bedienelemente (4) und der dazugehörigen Bedienelemente-Leiterplatte (6) aufweisenden Frontteil (1) und mit einem an dem Frontteil (1) lösbar befestigbaren eine Haupt-Leiterplatte (8) tragenden Rückteil (2), wobei die Bedienelemente-Leiterplatte (6) und die Haupt-Leiterplatte (8) mittels eines Breitbandkabels (23) elektrisch verbindbar sind.

## Beschreibung

Die Erfindung betrifft eine Montagehilfe für den Einbau einer Leiterplatte in ein mindestens aus zwei Teilen bestehendes Gehäuse.

Es ist insbesondere in der Kraftfahrzeugzulieferindustrie bekannt, Steuereinheiten für Instrumente oder Aggregate als in sich geschlossene Einheiten zu fertigen, die problemlos in die Armaturen integriert werden können. Diese Steuereinheiten haben Gehäuse, die zumeist aus einem Frontteil und einem damit verschraubten Rückteil bestehen. In dem Gehäuse sind alle Bedien-, Kontroll- und Steuerfunktionen für ein oder mehrere Aggregate vereinigt.

Die Bedien- und Kontrollelemente sind in Form von Knöpfen, Schaltern und Lampen dem Fahrer zugänglich in das Frontteil integriert. Alle Elemente sind meist auf einer Leiterplatte, der Bedienelemente-Leiterplatte, verschaltet. Diese Bedienelemente-Leiterplatte wird zweckmäßigerweise direkt hinter dem Bedienungspanel mit dem Frontteil verschraubt und bildet so mit dem Frontteil eine kompakte und stabile Einheit.

Die Regelung der Aggregate wird auf einer weiteren in dem Gehäuse befindlichen Leiterplatte, der Haupt-Leiterplatte, realisiert. Die Haupt-Leiterplatte muß mit den Aggregaten, Sensoren oder sonstigen außenliegenden Elementen verbunden werden. Da diese Verbindungen nur beim Einbau der Steuereinheit in das Fahrzeug oder bei der Reparatur hergestellt oder unterbrochen werden müssen, sind sie von Hinten durch das Rückteil der Steuereinheit zugänglich. Die Verbindung geschieht über Stecker auf der Haupt-Leiterplatte, die wegen der großen mechanischen und elektrischen Belastung sehr robust ausgelegt sein müssen.

Wegen der mechanischen Belastung ist es sinnvoll, die Haup-Leiterplatte fest mit dem Rückteil zu verbinden. So können die Stecker betätigt werden, ohne daß es zur Beeinträchtigung der anderen in dem Gehäuse befindlicher Bauteile kommt. Wie das Frontteil bildet auch das Rückteil mit der Haupt-Leiterplatte eine feste Einheit.

Die elektrische Verbindungen zwischen der Bedienelemente-Leiterplatte und der Haupt-Leiterplatte wird über Breitbandkabel hergestellt, die an mindestens einem ihrer Enden Stecker tragen und damit in entprechende Buchsen auf der anderen Platine steckbar sind. Um den Raum zwischen den montierten Leiterplatte nicht unnötig mit Breitbandkabeln zu erfüllen, ist es vorteilhaft, diese möglichst kurz zu halten. Dadurch wird eine mögliche Beschädigung der Kabel durch Abknicken oder eine mögliche Beschädigung der elektronischen Bauteile durch das Kabel vermieden.

Je kürzer die Kabel, desto schwerer der Zusammenbau der Steuereinheit, da die Kabel den größt möglichen Abstand zwischen dem Frontteil und dem Rückteil festlegen, der ausreichend groß sein muß, um den Eingriff zum Aufstecken der Stecker zu gewährleisten.

Je nach der Konzeption tritt beim Zusammenbau der bekannten Steuereinheiten eines der Probleme auf.

Ist die Haupt-Leiterplatte sicher an dem Rückteil angeschraubt, dann ist entweder das Aufstecken der Stecker schwierig, weil das Kabel sehr kurz ist, oder das Kabel ist so lang, daß es bei zusammengebauter Steuereinheit zwischen den Platinen eingeklemmt wird.

Wird hingegen die Haupt-Leiterplatte mit der Bedienelemente-Leiterplatte gekoppelt, ist zwar der Einbau komfortabel, beim Zusammenstecken der massiven Steckkontakte durch das Rückteil, kommt es jedoch zu starken Belastungen und eventuell zur Zerstörung der Leiterplatten oder deren Halterungen.

Aus DE-A 29 20 578 ist es beispielsweise bekannt, mehrere Leiterplatten im Stapel übereinander anzuordnen, der im Rückteil des Gehäuses fixiert ist. Das seitliche Verschieben der Leiterplatten untereinander wird mittels durch den Plattenstapel gesteckter Führungsstifte vermieden, während ihr Abstand mit Distanzstücken, die auf die Führungsstifte schiebbar sind, bestimmt ist. Das Frontteil mit den Bedienelementen wird nach dem Einbau des Plattenstapels aufgesetzt. Um das Frontteil abheben zu können, müssen die Verbindungskabel zwischen der obersten Leiterplatte und den Bedienelementen lang genug sein, um genügend Abstand zum Einführen einer Hand herstellen zu können. Derart lange Kabel gehen mit den genannten Nachteilen einher.

Aufgabe der vorliegenden Erfindung ist es, eine einfache Montage von Leiterplatten, die an den Gehäuseteilen lösbar befestigt und über Kabel miteinander verbunden sind, zu gewährleisten.

Diese Aufgabe wird erfindungsgemäß dadurch gelöst, daß mindestens ein als ein Distanzstück wirkender Verschraubungsträger auf die Innenseite des Frontteils oder auf ein mit der Innenseite des Frontteils fest verbundenes Bauteil axial verschieblich aufsteckbar ist, daß die Leiterplatte auf die dem Rückteil zugewandte Rückseite des Verschraubungsträgers formschlüssig aufsteckbar ist, daß der Verschraubungsträger Gewindebohrungen aufweist, die durch Öffnungen im Rückteil zugänglich sind und daß durch das Festschrauben der Verschraubungsträger mittels der Gewindebohrungen die Leiterplatte gegen das Rückteil klemmbar ist.

Ein Ausführungsbeispiel der Erfindung ist in den Zeichnungen dargestellt und wird im folgenden näher beschrieben.

Es zeigen:

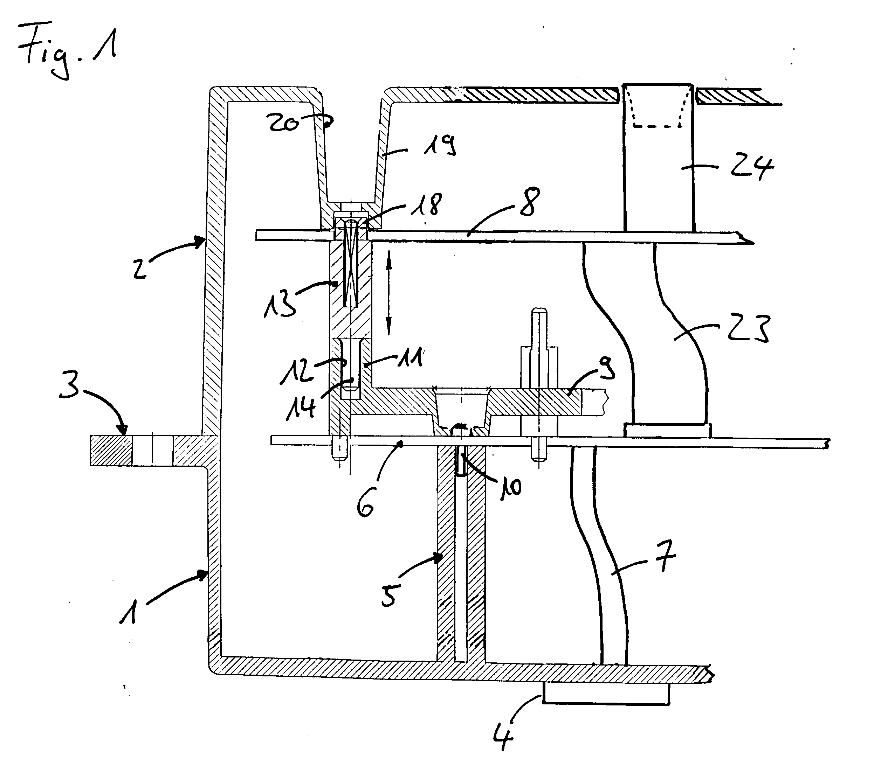

- Figur 1:: Einen Schnitt durch einen Teil des Gehäuses einer Steuereinheit.

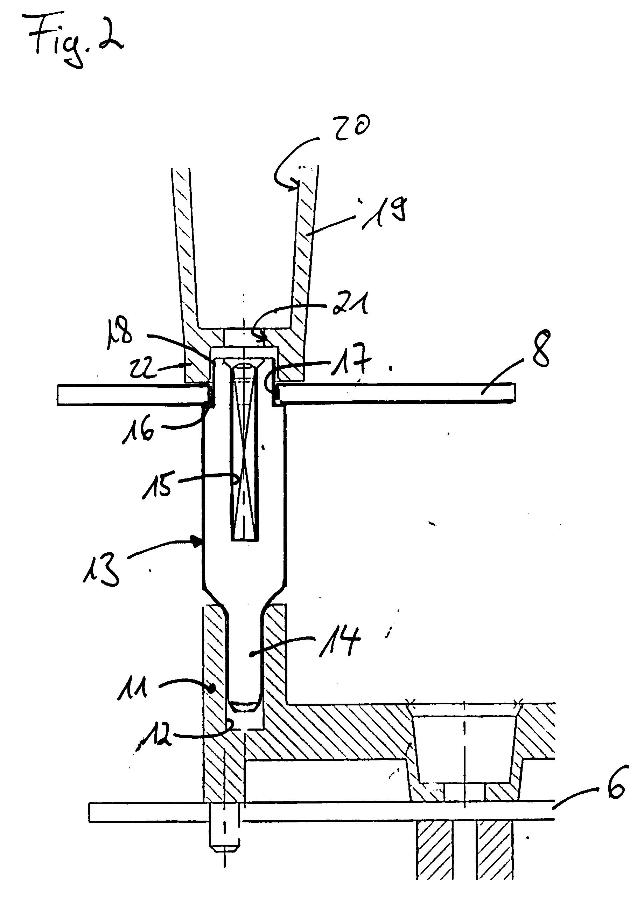

- Figur 2:: Ausschnitt mit Verschraubungsträger.

Das Gehäuse einer Steuereinheit ist vorteilhafterweise aus Kunststoff und hat einen nach vorne in Richtung Fahrer liegenden Frontteil 1 und einen nach hinten in das Armaturenbrett ragenden am Frontteil 1 festschraubbaren Rückteil 2. Das zusammengesetzte Gehäuse wird mittels der Halterungen 3 an das Armaturenbrett eines Kraftfahrzeuges montiert, die an den Frontteil 1 seitlich angeformt sind.

Am Frontteil 1 sind Bedienelemente insbesondere Schalter 4 dem Fahrer zugänglich angeordnet. An der Innenseite des Frontteils 1 sind Stützen 5 angeformt, auf denen eine Bedienelemente-Leiterplatte 6 insbesondere mit Schrauben abnehmbar befestigt ist. Die Bedienelemente-Leiterplatte 6 ist über ein Flachbandkabel 7 mit den Schaltern 4 elektrisch verbunden.

Auf den am Frontteil 1 angeformten Stützen 5 sind desweiteren Abstandshalter 9 durch Schrauben 10 befestigt. Die Abstandshalter 9 sichern den Abstand zwischen der Bedienelemente-Leiterplatte 6 und einer dahinter liegenden Haupt-Leiterplatte 8. Es ist besonders vorteilhaft, die Bedienelemente-Leiterplatte 6 auf die Stützen aufzustecken, um sie dann mit den dahinterliegenden Abstandshaltern 9 daran festzuschrauben.

In die Abstandshalter 9 insbesondere in an die Abstandshalter angeformte Stützen 11 sind nach hinten offenen Bohrung 12 eingebracht. In diese Bohrungen sind weitere, als Distanzstücke ausgebildete Verschraubungsträger 13 mit ihren an Füße 25 angeformten nach vorne ragenden Bolzen 14 axial beweglich einsteckbar.

Hinten, auf der den Bolzen 14 abgewandten Seite, sind die Füße 25 zu einem Zapfen 18 ausformt. Auf diese Zapfen 18 kann die Haupt-Leiterplatte 8 mit den sie eingebrachten Bohrungen 17 gesteckt werden und stößt an den durch die Füße 25 gebildete Auflagen 16 an. Axial durch die Zapfen 18 sind in den Füßen 25 Gewindebohrungen 15 eingebracht.

In das Rückteil 2 sind nach Innen ragende Dome 19 mit einer von außen zugänglichen Ausnehmung 20. An der nach Innen ragenden Spitze sind die Dome zu Kappen 22 geformt, die die Zapfen 18 bedecken, wenn das Frontteil 1 mit dem Rückteil 2 verschraubt ist. Die Kappen 22 sind mit den Bohrungen 21 versehen. Durch die Bohrungen 21 werden die Füße 25 mit der darauf gesteckten Haupt-Leiterplatte 8 vermittels der Gewindebohrungen 15 gegen das Rückteil 2 geschraubt. Auf diese Weise wirken die Füße 25 der Verschraubungsträger 13 wie eine an der Haupt-Leiterplatte 8 gehalterte Mutter, mit der die Haupt-Leiterplatte 8 gegen das Rückteil geschraubt werden kann.

Die Montage der Steuereinheit läuft durch die als Montagehilfe wirkenden Verschraubungsträger 13 nach folgendem Schema:

Zunächst wird die Bedienelemente-Leiterplatte 6 auf die Stützen 5 des Frontteils 1 montiert und mit den Schaltern 4 über das Kabel 7 verbunden. Dann werden die Abstandshalter mit der Bedienelemente-Leiterplatte 6 bzw. mit den Stützen 5 verschraubt. Jetzt werden die Verschraubungsträger 13 mit ihren Füßen 25 eingesteckt und dann die HauptLeiterplatte 8 aufgesetzt. Mit dem Flachbandkabel 23 wird die Bedienelemente-Leiterplatte 6 und Haupt-Leiterplatte 8 verbunden. Nun wird das Rückteil 2 mit dem Frontteil 1 zusammengefügt. Zuletzt läßt sich problemlos eine Schraube durch die Dome 19 stecken und in die Gewindebohrungen 15 schrauben. Da die Verschraubungsträger 13 axial verschiebbar sind, ziehen sie sich gegen das Rückteil und fixieren so die Haupt-Leiterplatte 8.

Mit der offenbarten Montagehilfe ist die Haupt-Leiterplatte 8 sicher gegen das Rückteil 2 verschraubt, so daß die Stecker 24 problemlos benutzbar sind. Gleichzeitig ist durch die besondere Montage gewährleistet, daß das Flachbandkabel 23 möglichst kurz ist und somit nicht zu Problemen in dem Zwischenraum zwischen Bedienelemente-Leiterplatte 6 und Haupt-Leiterplatte 8 führen kann.

## Patentansprüche

1. Montagehilfe für den Einbau von Leiterplatten (6,8) in ein aus mindestens zwei Teilen bestehendes Gehäuse, mit einem elektrische Bedienelemente (4) und der dazugehörigen Bedienelemente-Leiterplatte (6) aufweisenden Frontteil (1) und mit einem an dem Frontteil (1) lösbar befestigbaren eine Haupt-Leiterplatte (8) tragenden Rückteil (2), wobei die Bedienelemente-Leiterplatte (6) und die Haupt-Leiterplatte (8) mittels eines Breitbandkabels (23) elektrisch verbindbar sind,
**dadurch gekennzeichnet,**
- daß mindestens ein als ein Distanzstück wirkender Verschraubungsträger (13) auf die Innenseite des Frontteils (1) oder auf ein mit der Innenseite (1) des Frontteils fest verbundenes Bauteil (9) axial verschieblich aufsteckbar ist,
- daß die Leiterplatte (8) auf die dem Rückteil (2) zugewandte Rückseite des Verschraubungsträgers (13) formschlüssig aufsteckbar ist,
- daß der Verschraubungsträger (13) Gewindebohrungen (15) aufweist, die durch Öffnungen (21) im Rückteil (2) zugänglich sind und
- daß durch das Festschrauben der Verschraubungsträger (13) mittels der Gewindebohrungen (15) die Leiterplatte (8) gegen das Rückteil (2) klemmbar ist.

2. Montagehilfe nach Anspruch 1,
**dadurch gekennzeichnet**, daß die Verschraubungsträger (13) Füße (25) haben, die einen Stift oder Bolzen (14) aufweisen.

3. Montagehilfe nach Anspruch 1 und 2,
**dadurch gekennzeichnet,** daß in der Innenseite des Frontteils (1) oder in einem mit der Innenseite (1) des Frontteils fest verbundenem Bauteil Öffnungen (12) mit dem Durchmesser und der Verteilung der Bolzen (14) eingebracht sind.

4. Montagehilfe nach Anspruch 2,
**dadurch gekennzeichnet**, daß die Füße (25) an der dem Rückteil (2) zugewandten Seite Zapfen (18) tragen, die den Durchmesser und die Verteilung von Öffnungen (17) in der Hauptplatine (8) aufweisen.

5. Montagehilfe nach einem der genannten Ansprüche,
**dadurch gekennzeichnet**, daß die Zapfen (18) durch die Öffnungen (17) in der Hauptplatine (8) fassen.

6. Montagehilfe nach einem der genannten Ansprüche,
**dadurch gekennzeichnet**, daß die Hauptplatine (8) auf den zu Auflagen (16) geformten Ansätzen der Zapfen (18) formschlüssig aufliegt.

7. Montagehilfe nach einem der genannten Ansprüche,
**dadurch gekennzeichnet,** daß auf der Innenseite des Rückteils (2) zu Domen (19) geformte Ständer angebracht sind, die eine durchbohrte, nach Innen offene Kappen (22) tragen.

8. Montagehilfe nach Anspruch 7,
**dadurch gekennzeichnet,** daß die Kappen (22) den Durchmesser und die Verteilung der Zapfen (18) aufweisen.

9. Montagehilfe nach einem der genannten Ansprüche,
**dadurch gekennzeichnet,** daß zwischen dem Boden einer Kappe (22) und dem Kopf eines Zapfen (18) eine Distanz besteht.

10. Montagehilfe nach einem der genannten Ansprüche,
**dadurch gekennzeichnet,** daß in die Zapfen (18) jeweils eine Gewindebohrung (15) eingebracht ist.

11. Montagehilfe nach einem der genannten Ansprüche,
**dadurch gekennzeichnet,** daß in die Zapfen (18) mittels einer durch die Öffnung (21) einbringbaren Schraube ein Gewinde einschneidbar ist.

12. Montagehilfe nach einem der genannten Ansprüche,
**dadurch gekennzeichnet**, daß der Verschraubungsträger (13) mit dem als Abstandshalter ausgebildeten Bauteil (9) durch ein flexibles Teil insbesondere eine Rippe einteilig verbunden ist.
